# EUROPEAN PATENT APPLICATION

(11) **EP 4 300 827 A1**
(43) Date of publication of application: **03.01.2024**
(21) Application number: 23182396.4
(22) Date of filing: 29.06.2023
(51) Int. Cl.: H03K 19/0185, G05F 3/26

(54) **PROGRAMMABLE TRIMMING BIT IMPLEMENTATION CIRCUIT AND DRIVING CIRCUIT**

(30) Priority: 30.06.2022 CN 202210762006
(71) Applicant: Huada Semiconductor Co., Ltd., Pudong New Area, Shanghai 201203 (CN)
(72) Inventor: XU, Jian, 201203 Pudong New Area, Shanghai (CN); XU, Jingwei, 201203 Pudong New Area, Shanghai (CN)
(74) Representative: Canzler & Bergmeier Patentanwälte Partnerschaft mbB

(57) **Abstract**

A programmable trimming bit implementation circuit (fig. 2, 3) and a driving circuit (fig. 1: without Q1, Q2, fig. 4) are provided, and the programmable trimming bit implementation circuit includes: a pulse-generating circuit (fig. 2: TD0, TPD1, U7-U11, fig. 3: U16, U17) configured to generate a pulse clock signal (CLK_HS) to be provided to a latch circuit (fig. 2: U1, fig. 3: U23); a latch circuit configured to latch bits of programmable current input signals (fig. 2: D0_HS, fig. 3: D1_HS) by applying the pulse clock signal; a current mirror circuit (fig. 2: IB1, NM0, NM1, NM2, fig. 3: NM3) configured to provide drive currents for the pulse-generating circuit and the latch circuit; and a programmable drive current implementation circuit (fig. 1: without Q1, Q2, fig. 4) configured to adjust currents (current sources: MP1to MP4, current sink: MN1 to MN4) based on the latched bits (fig. 2: B0_HS, fig. 3: B1_HS).

## Description

### FIELD OF THE INVENTION

The present disclosure relates to the technical field of integrated circuits, in particular, to a programmable trimming bit implementation circuit and a driving circuit.

### BACKGROUND OF THE INVENTION

In certain specific applications, to meet requirements such as electromagnetic compatibility of a system, it is necessary to adjust the sizes of the driving current source and driving current sink of the system. In the prior art, programmable current functionality is only available in low-voltage (such as 48V) drivers. Generally, the magnitudes of driving currents of high-voltage drive chips are adjusted by using a resistor connected in series with a gate of a drive transistor external to the chips. In the process of system debugging, this not only increases the working complexity and working time of debugging personnel, but also increases the debugging cost.

### SUMMARY OF THE INVENTION

The present disclosure provides a programmable trimming bit implementation circuit and a driving circuit to solve the problem that existing programmable current functionality cannot be implemented in high-voltage drive chips.

In order to solve the above technical problems, the present disclosure provides a programmable trimming bit implementation circuit, including:
a pulse-generating circuit configured to generate a pulse clock signal to be provided to a latch circuit;
a latch circuit configured to latch bits of programmable current input signals by applying the pulse clock signal;
a current mirror circuit configured to provide drive currents for the pulse-generating circuit and the latch circuit; and
a programmable drive current implementation circuit configured to adjust currents based on the latched bits.

Optionally, in the programmable trimming bit implementation circuit, the pulse-generating circuit includes:
a first rising edge signal delay module configured to generate a first rising edge signal delay signal based on an initial level signal; and
a rising edge signal pulse generating module configured to generate a fixed time pulse signal based on the rising edge signal of the first rising edge signal delay signal;
wherein the pulse signal is provided to a control terminal on a branch of the current mirror circuit to generate the pulse clock signal.

Optionally, in the programmable trimming bit implementation circuit, the number of the latch circuits is at least one, and each latch circuit includes:
a D flip-flop, whose first input terminal receives an Nth bit of the programmable current input signal, whose second input terminal receives the pulse clock signal, whose output terminal outputs a programmable current latch output signal.

Optionally, in the latch circuit of the programmable trimming bit implementation circuit:
the Nth bit of the programmable current input signal and the first rising edge signal delay signal are provided to the control terminal on an Nth branch of the current mirror circuit after passing through a NAND gate, so as to generate the bits of the programmable current input signal, and then provided to the first input terminal of the D flip-flop after passing a second rising edge signal delay module;
the pulse clock signal is provided to the second input terminal of the D flip-flop after passing a third rising edge signal delay module.

Optionally, in the programmable trimming bit implementation circuit, the current mirror circuit includes a plurality of branches and a current source providing a bias current under a power domain.

Specifically, the current source and each of the plurality of branches include a current mirror transistor, each of the plurality of branches also includes a high-voltage device as a control terminal, and a circuit composed of a resistor and a Zener diode connected in parallel.

Optionally, in the programmable trimming bit implementation circuit:
the programmable drive current implementation circuit is configured to generate a multi-bit decoded output signal based on a plurality of programmable current latch output signals, so as to control magnitudes of currents of current sources and current sinks.

Optionally, in the programmable trimming bit implementation circuit, the programmable drive current implementation circuit includes:
a multi-bit decoding circuit configured to generate a multi-bit decoded output signal based on a plurality of programmable current latch output signals; and
a plurality of current gear circuits respectively including a current source drive transistor and a current sink drive transistor for each gear configured to control the on-off of the current source drive transistor and the current sink drive transistor based on the multi-bit decoded output signal.

The present disclosure also provides a driving circuit including the programmable trimming bit implementation circuit as described above, including:
a dead-time generating circuit configured to generate a high-side dead-time signal and a low-side dead-time signal by obtaining a high-side driver sampling signal and a low-side driver sampling signal output by the programmable trimming bit implementation circuit;
wherein there is a dead time between the high-side dead-time signal and the low-side dead-time signal, so as to avoid simultaneous conduction of power devices for both a high-side driving circuit and a low-side driving circuit during operation.

Optionally, the driving circuit further includes:
a first level conversion circuit configured to perform conversion between VSS levels and VCOM levels, and convert a signal ground of input signals into a power ground, so as to avoid interference caused by noise in a chip; and
a second level conversion circuit configured to convert the input signal into a floating pulse signal referenced with a high voltage ground.

Optionally, the driving circuit further includes:
a bootstrap circuit configured to include a bootstrap diode and a bootstrap capacitor, wherein the bootstrap diode is connected between a low-side power and the bootstrap capacitor, and the bootstrap capacitor is connected between the bootstrap diode and the high voltage ground;
wherein, when a low-side driving transistor is on and a high-side driving transistor is off, the high voltage ground is down, and the low-side power is charged by the bootstrap diode.

In the programmable trimming bit implementation circuit and driving circuit according to the present disclosure, a technical solution is proposed for realizing programmable high-voltage (such as 150V) driving source currents and sink currents by means of electrical pulses and latching. Since this technology is realized by means of electrical pulses and latching, the programmable circuit have no power consumption after programming. The present disclosure can realize the conversion of programming signals from low-voltage domains to high-voltage domains simply by using high-voltage NMOS devices, thereby easing the restrictions on the implementation process. And at the same time, the present disclosure can also be implemented in low-voltage driving circuits. The present disclosure can programatically meet the function of on-line programmable current high-voltage driving, and effectively reduce the complexity and cost of system debugging.

### BRIEF DESCRIPTION OF THE DRAWINGS

FIG.1 is a schematic working principle view of a floating gate driving circuit architecture according to one embodiment of the present disclosure;
FIG.2 is a partial schematic view of a programmable trimming bit implementation circuit according to one embodiment of the present disclosure;
FIG.3 is a schematic view of a latch circuit in the programmable trimming bit implementation circuit according to one embodiment of the present disclosure;
FIG.4 is a schematic view of a programmable drive current implementation circuit in the programmable trimming bit implementation circuit according to one embodiment of the present disclosure.

Reference Numerals: 10-dead-time generating circuit; 20-first level conversion circuits; 30-second level conversion circuit.

### DETAILED DESCRIPTION

The present disclosure will be further described below in conjunction with specific embodiments with reference to the accompanying drawings.

It should be noted that elements in the various drawings may be exaggerated for the sake of illustration, and are not necessarily true to scale. In the various drawings, the same reference numerals will be used throughout to designate the same or equivalent elements.

Unless indicated otherwise, in the present specification, "disposed on", "disposed above" and "disposed onto" do not exclude the cases where there is an internal between the two. In addition, "disposed on or above" only indicates the relative positional relationship between the two elements, and in certain situations, such as reversing the direction of elements, it can also be called "disposed under or below", and vice versa.

In the present specification, each embodiment is only intended to illustrative, and not restrictive of the scope of the present disclosure.

Unless otherwise indicated, in the present specification, the quantifiers "a", "an" do not exclude the cases of multiple elements.

It should also be noted that in some embodiments of the present disclosure, for the sake of clarity and simplicity, only some parts or elements are shown. And those skilled in the art will understand that extra parts or elements could be added based on the need for specific scenarios, under the teachings of the present disclosure. In addition, unless otherwise stated, features in different embodiments of the present disclosure can be combined with each other. For example, a feature in a second embodiment may be used to replace a corresponding or equivalent or similar feature in a first embodiment, and the resulting embodiment also falls within the scope or description of the present disclosure.

It should also be noted here that within the scope of the present disclosure, descriptions such as "same", "equal", and "equal to" do not mean that the two values are absolutely equal, but allow a certain reasonable error, that is, the terms also cover "substantially same", "substantially equal" and "substantially equal to". By analogy, in the present disclosure, the terms "perpendicular to", "parallel to" and the like referring to directions also cover the meanings of "substantially perpendicular to" and " substantially parallel to".

Furthermore, the numbering of the steps of the various methods of the present disclosure do not limit the execution sequence of the method steps. Unless indicated otherwise, the various method steps may be performed in a different sequence.

The programmable trimming bit implementation circuit and driving circuit proposed by the present disclosure will be further described in detail, in conjunction with the accompanying drawings and specific embodiments. The advantages and features of the present disclosure will become clearer from the following description. It should be noted that all the drawings are in a simplified form and may use imprecise scales, and are only intended to illustrate the embodiments of the present disclosure.

One purpose of the present disclosure is to provide a programmable trimming bit implementation circuit and driving circuit to solve the problem of power consumption required by existing driving circuits when realizing programmable current functions.

Another purpose of the present disclosure is to provide a programmable trimming bit implementation circuit and driving circuit to solve the problem that existing driving circuits need complementary devices to realize circuit design.

Another purpose of the present disclosure is to provide a programmable trimming bit implementation circuit and driving circuit to solve the problem that currently only low-voltage driving programmable current functions can be realized.

In order to achieve the above purposes, the present disclosure provides a programmable trimming bit implementation circuit and a driving circuit, the programmable trimming bit implementation circuit includes : a pulse-generating circuit configured to generate a pulse clock signal to be provided to a latch circuit; a latch circuit configured to latch bits of programmable current input signals by applying the pulse clock signal; a current mirror circuit configured to provide drive currents for the pulse-generating circuit and the latch circuit; and a programmable drive current implementation circuit configured to adjust currents based on the latched bits.

The present disclosure implements the current adjustment of a current source and a current sink in high-voltage domains through on-line programming.

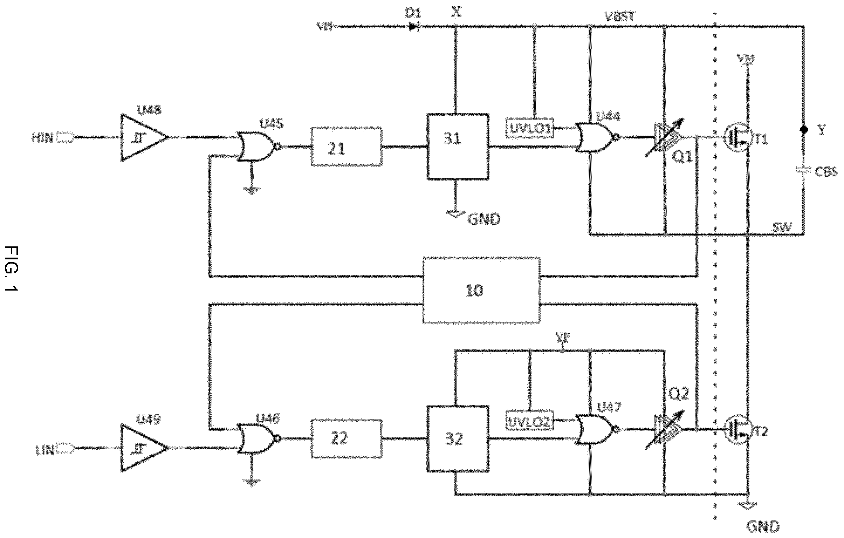

FIG.1 provides a first embodiment of the present disclosure, which shows the overall architecture and working principle of the driving circuit. The driving circuit includes an upper bridge and a lower bridge. In one embodiment, the upper bridge is used in high-voltage domains, and the lower bridge is used in low-voltage domains. Unless otherwise specified, they refer to the same object.

The circuit working principle of the driving circuit that adopts a floating gate architecture in FIG.1: When the circuit is working normally, the phases of the input level signal HIN in high-voltage domains and the input level signal LIN in low-voltage domains should be strictly opposite, and they are respectively shaped by shaping circuits U48 and U49, and then sent to NOR gates U45 and U46 together with output signals (i.e., a high-side dead-time signal and a low-side dead-time signal) of a dead-time generating circuit 10.

The dead-time generating circuit 10 generates the high-side dead-time signal and the low-side dead-time signal, based on a high-side driver sampling signal (which connects to a gate of a high-side driving transistor T1, that is, the output of the programmable trimming bit implementation circuit Q1) and a low-side driver sampling signal (which connects to a gate of a low-side driving transistor T2, that is, the output of the programmable trimming bit implementation circuit Q2) input to the dead-time generating circuit 10, wherein there is a dead time between the high-side dead-time signal and the low-side dead-time signal, so as to avoid simultaneous conduction of power devices for both the high-side driving circuit and the low-side driving circuit during operation. The high-side/low-side driver sampling signal is output to the dead-time generating circuit 10, so that there is a dead time between the high-side and low-side signals, to prevent simultaneous conduction of the high-side power device (i.e., T1) and the low-side power devices (i.e., T2) during operation.

Further, in order to prevent interference caused by noise in a chip, the chip's power ground and signal ground are generally separated. Output signals of the NOR gates U45 and U46 convert the signal ground into the power ground through their corresponding VSS/VCOM level conversion circuits (i.e., first level conversion circuits 21, 22); specifically the first level conversion circuits 21, 22 perform the conversion between VSS levels and VCOM levels, and convert the signal ground of input signals (i.e., the output signals of U45, U46) into the power ground, so as to avoid interference caused by noise in the chip.

A second level conversion circuit 31 is configured to convert the power ground of input signals (i.e., the output signals of the first level conversion module 21) into a (level) signal referenced to a high voltage ground SW, realizing the conversion of input signals from low high-voltage domains to high-voltage domains.

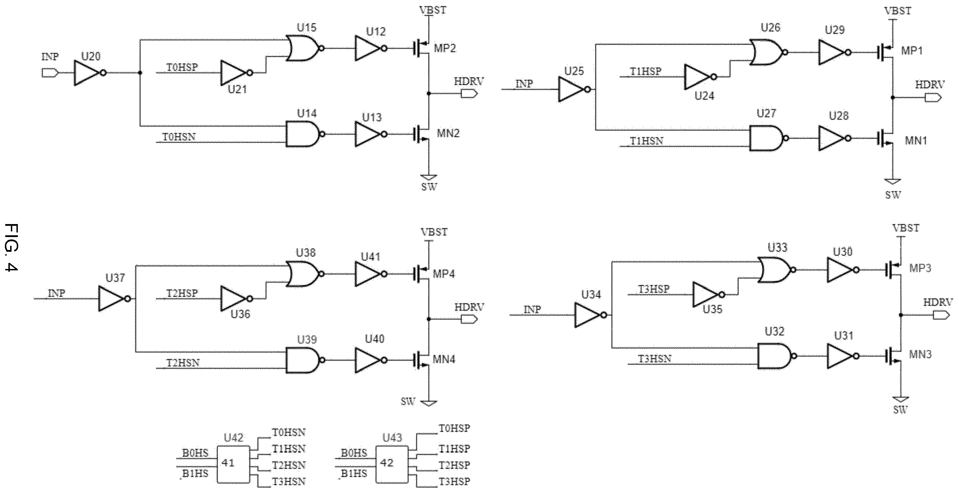

Output signals of both the second level conversion circuit 31 and an under-voltage lock-out circuit UVLO 1 are jointly provided to the NOR gate U44, and output signals of the NOR gate U44 are an input signal INP of the programmable drive current implementation circuit, as shown in FIG.4. The programmable trimming bit implementation circuit Q1 outputs the high-side driver sampling signal, then the high-side driver sampling signal is provided to the dead-time generating circuit and the gate of the high-side driving transistor T1 (such as MOS or IGBT), and a source of the high-side driving transistor T1 is connected with the high voltage ground SW, the high voltage ground SW is also connected to U44 and the programmable trimming bit implementation circuit Q1. The under-voltage lock-out circuit UVLO 1 not only provides under-voltage protection by controlling the signals on the main branch of high-voltage domains, but also connects to an RN input terminal of the D flip-flop (U1, U23) in the programmable trimming bit implementation circuit Q1. When an under-voltage of the power supply VBST occurs, the D flip-flop resets and the signals on the main branch are prevented from turning on T1, thereby preventing voltage shortage.

Power supply terminals of a second level conversion circuit 32, an under-voltage lock-out circuit UVLO 2, a NOR gate U47, and the programmable trimming bit implementation circuit Q2 are all connected to a low-voltage power supply VP, and a ground terminal of the second level conversion circuit 32 is connected with a power ground GND. Ground terminals of the NOR gate U44 and the programmable trimming bit implementation circuit Q1 are all connected to the high-voltage ground SW, and a drain of T1 is connected with a high-voltage side power supply VM.

The structure of the programmable trimming bit implementation circuit Q2 and the programmable trimming bit implementation circuit Q1 may be the same or different, as long as the programmable current function in low-voltage domains can be realized.

When the programmable trimming bit implementation circuit Q2 has the same structure as the programmable trimming bit implementation circuit Q1, output signals of both the second level conversion circuit 32 and the under-voltage lock-out circuit UVLO 2 are jointly provided to the NOR gate U47, and output signals of the NOR gate U47 are an input signal INP of the programmable drive current implementation circuit in the programmable trimming bit implementation circuit Q2. The programmable trimming bit implementation circuit Q2 outputs the low-side driver sampling signal, then the low-side driver sampling signal is provided to the dead-time generating circuit and a gate of the low-side driving transistor T2 (such as MOS or IGBT), and a source of the low-side driving transistor T2 is connected with the power ground GND, the power ground GND is also connected to U47 and the programmable trimming bit implementation circuit Q2.The under-voltage lock-out circuit UVLO 2 not only provides under-voltage protection by controlling the signals on the main branch of low-voltage domains, but also connects to the RN input terminal of the D flip-flop in the programmable trimming bit implementation circuit Q2. When an under-voltage of the power supply VP occurs, the D flip-flop resets and the signals on the main branch are prevented from turning on T2, thereby preventing voltage shortage.

In one embodiment, a bootstrap circuit is used for power supply. The high-voltage circuit is powered by the high-side power supply VBST via a bootstrap method. The bootstrap circuit is composed of a bootstrap diode D1 and a bootstrap capacitor CBS. The bootstrap diode D1 is connected between the power supply VP and the bootstrap capacitor CBS, and the bootstrap capacitor CBS is connected between the bootstrap diode D1 and the high voltage ground SW. An example of the working principle is as follows:

Assuming that the voltage of the power supply VP is 15V, the transistor T2 is on and T1 is off, the bootstrap capacitor CBS is charged by the power supply VP through the bootstrap diode D1, the voltage at point X is 14.3V, and the voltage at point Y is 14.3V. Then transistor T1 is turned on and transistor T2 turned off, and a 100V voltage is applied at the power supply VM, the voltage at point Y becomes 100V+14.3V, thereby realizing the bootstrap power supply.

In certain specific applications, to meet requirements such as electromagnetic compatibility of a system, it is necessary to adjust the sizes of driving current sources and driving current sinks. For conventional high-voltage drive chips, the magnitudes of driving currents could only be adjusted through a resistor connected in series with a gate of a drive transistor external to the chips. In the process of system debugging, this not only increases the working complexity and working time of debugging personnel, but also increases the debugging cost. The present disclosure can conveniently and flexibly adjust the sizes of both current sinks (i.e., MN1, MN2, MN3 and MN4 in FIG.4) and current sources (i.e., MP1, MP2, MP3 and MP4 in FIG.4) for high-voltage driving, by means of software programming. Indicators such as electromagnetic compatibility of the system could be satisfied, thereby effectively reducing the complexity and cost of system debugging.

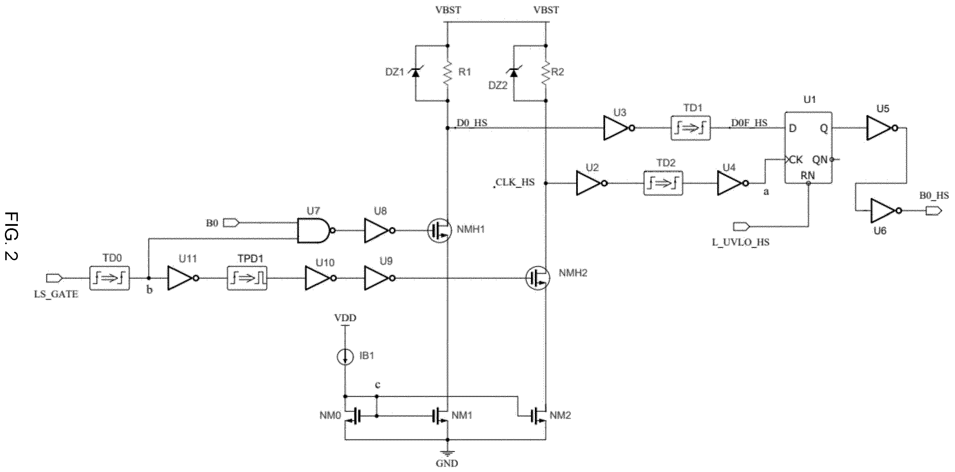

FIGs 2, 3 and 4 provide a second embodiment of the present disclosure, which show the working principle of the programmable trimming bit implementation circuit of the driving circuit. Taking programmable current selection having four gears as an example, the second embodiment adopts a high-voltage driving circuit, and the programmable current implementation in high-voltage domains of the second embodiment is described below.

FIG.2 is a partial schematic view of the programmable trimming bit implementation circuit, which only includes one latch circuit. The programmable trimming bit implementation circuit includes a pulse-generating circuit configured to generate a pulse clock signal based on an initial level signal, so as to be provided to a latch circuit; a latch circuit configured to latch bits of programmable current input signals by applying the pulse clock signal; a current mirror circuit configured to provide drive currents for the pulse-generating circuit and the latch circuit; and a programmable drive current implementation circuit configured to adjust currents based on the latched bits.

The pulse-generating circuit includes: a first rising edge signal delay module configured to generate a first rising edge signal delay signal based on an initial level signal; and a rising edge signal pulse generating module configured to generate a fixed time pulse signal based on the rising edge signal of the first rising edge signal delay signal; wherein the pulse signal is provided to the control terminal on a branch of the current mirror circuit to generate the pulse clock signal.

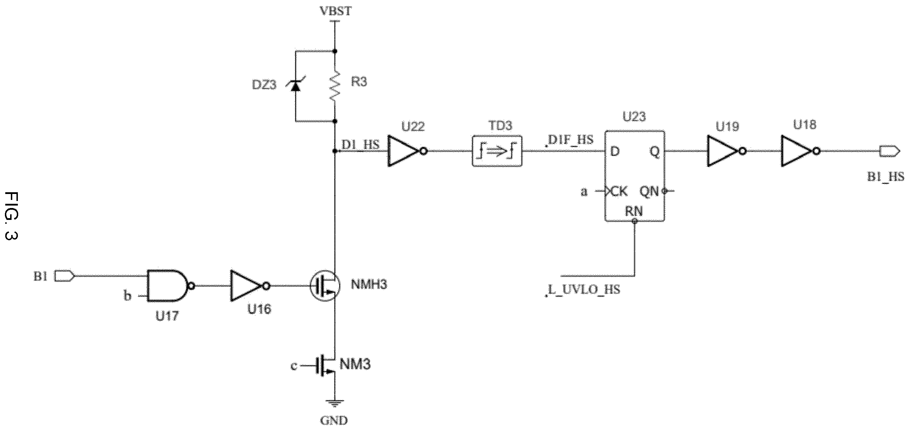

The number of the latch circuits is at least one, and each latch circuit includes: a D flip-flop, whose first input terminal receives an Nth bit of the programmable current input signal, whose second input terminal receives the pulse clock signal, whose output terminal outputs a programmable current latch output signal; the Nth bit of the programmable current input signal and the first rising edge signal delay signal are provided to the control terminal on an Nth branch of the current mirror circuit after passing through a NAND gate, then corresponding output signals are provided to the first input terminal of the D flip-flop after passing a rising edge signal delay module; the pulse clock signal is provided to the second input terminal of the D flip-flop after passing a rising edge signal delay module. The embodiment takes 2 bits as an example, and each bit corresponds to a latch circuit (respectively corresponding to the latch circuits in FIG.2 and FIG.3).

The current mirror circuit includes a plurality of branches and a current source providing a bias current under a power domain, wherein: the current source and each of the plurality of branches include a current mirror transistor, each of the plurality of branches also includes a high-voltage device as a control terminal, and a circuit composed of a resistor and a Zener diode connected in parallel. In another embodiment, a circuit composed of a resistor and a Zener diode connected in parallel may be implemented by the resistor only. Among them, LS_GATE is an initial level signal, which can be an external signal or the output signal of Q1, i.e., the low-side driver sampling signals. B0 and B1 are two bits of the programmable current input signal in high-voltage domains (the bit of the programmable current input signal, which is low voltage). When L_UVLO_HS (UVLO 1 output) is low, the high-voltage domains are in an under-voltage protection state, and signals B0_HS and B1_HS are programmable current output signals in high-voltage domains, that is, latch signals.

TD0, TD1, TD2, and TD3 are rising edge signal delay modules, TPD1 is a rising edge signal pulse generating module, whose input rising edge signal generates a fixed time pulse signal, and IB1 is a bias current under a VDD power domain (a low-voltage domain). NM0, NM1, NM2, and NM3 (gates of the four are connected, and sources of the four are connected to GND) are current mirror transistors of a bias current under the power domain, a first branch, a second branch and a third branch of the current mirror circuit, respectively. NMH1, NMH2, and NMH3 are high-voltage devices (control terminals) of the first branch, the second branch and the third branch, respectively. U1 and U23 are a first D flip-flop and a second D flip-flop, both with a low reset function. DZ1, DZ2, and DZ3 are Zener diodes of the first branch, the second branch and the third branch, respectively.

The pulse-generating circuit includes: a first rising edge signal delay module TD0 configured to generate a first rising edge signal delay signal based on an initial level signal; and a rising edge signal pulse generating module TPD1 configured to generate a fixed time pulse signal based on the rising edge signal of the first rising edge signal delay signal, wherein the pulse signal is provided to the control terminal NMH2 on the second branch of the current mirror circuit to generate a pulse clock signal CLK_HS.

Specifically, as shown in FIG.2, in the programmable trimming bit implementation circuit, the first latch circuit includes: a first D flip-flop U1, whose first input terminal D receives a first bit B0 of the programmable current input signal, whose second input terminal CK receives the pulse clock signal CLK_HS, whose output terminal outputs a first programmable current latch output signal B0_HS; TD0 is the first rising edge signal delay module, which generates the first rising edge signal delay signal based on the initial level signal. TD1 is a second rising edge signal delay module, the first bit B0 of the programmable current input signal and the first rising edge signal delay signal are provided to the control terminal (a gate of NMH1) on the first branch of the current mirror circuit after passing through a NAND gate U7 and a NOR gate U8, so as to generate a bit D0_HS of the programmable current input signal, and then sent to the first input terminal D of the first D flip-flop U1 after passing the second rising edge signal delay module TD1; the pulse clock signal CLK_HS is provided to the second input terminal CK of the D flip-flop after passing a third rising edge signal delay module TD2.

As shown in FIG.3, the second latch circuit includes: a second D flip-flop U23, whose first input terminal D receives a second bit B1 of the programmable current input signal, whose second input terminal CK receives the pulse clock signal CLK_HS, whose output terminal outputs a second programmable current latch output signal B1_HS. The second bit B1 of the programmable current input signal and the first rising edge signal delay signal are provided to the control terminal (a gate of NMH3) on the third branch of the current mirror circuit after passing through a NAND gate U17 and a NOR gate U16, so as to generate a bit D1_HS of the programmable current input signal, and then sent to the first input terminal D of the second D flip-flop U23 after passing a fourth rising edge signal delay module TD3; the pulse clock signal CLK_HS is provided to the second input terminal CK of the second D flip-flop after passing a fifth rising edge signal delay module TD4.

The output signal L_UVLO_HS of UVLO 1 is provided to RN input terminals of U1 and U23; each of a bias current branch under the power domain (including a current source providing the bias current under the power domain) and the plurality of branches include a current mirror transistor, each of the plurality of branches also includes a high-voltage device as a control terminal, and a circuit composed of a resistor and a Zener diode connected in parallel. Specifically, the current mirror circuit includes a bias current IB1 under the power domain (one end of the bias current IB1 is connected with VDD and the other end of the bias current IB1 is connected with a drain and a gate of NM0), the first branch, the second branch, and the third branch, wherein in the second branch, a drain of NM2 is connected with a source of NMH2, a drain of NMH2 is connected with CLK_HS, as well as the parallel circuit of DZ2 and R2, and a gate of NMH2 is connected with TPD1; in the first branch, a drain of NM1 is connected with a source of NMH1 , a drain of NMH1 is connected with D0_HS, as well as the parallel circuit of DZ1 and R1, and the gate of NMH1 is connected with U7; in the third branch, a drain of NM3 is connected with s source of NMH3, and s drain of NMH3 is connected with D1_HS, as well as the parallel circuit of DZ3 and R3, and the gate of NMH3 is connected with U17.

The working principle of circuits in Figure 2 to 3 is as follows: when the LS_GATE signal changes from low to high, T2 turns on, and after TD0 delay, NMH2 is turned on via a fixed time pulse signal generated by TPD1, then converted to an upper bridge domain CLK_HS signal. At the same time, logic signals B0 and B1 are converted to signals D0_HS and D1_HS in the upper bridge domain, and the signals D0_HS and D1_HS are respectively latched at the rising edge of the CLK_HS signal through two DFFs U1 and U23, then output the latch output signals B0_HS and B1_HS in the upper bridge domain. By this way, the conversion of two-bit programmable current input signals B0 and B1 in low-voltage domains (VDD) into the two-bit programmable current latch output signal in the upper bridge domain is realized. As mentioned above, this circuit converts the two bits used for the programmable current from low-voltage domains to high-voltage domains (VBST-SW domain). In this implementation circuit, the level conversion of the two-bit programmable logic signal from low-voltage domains to high-voltage domains can be realized simply by three high-voltage NMOS, while in the prior art, each bit requires at least two NMOS to realize the level conversion. The circuit can program the magnitudes of currents in the upper bridge when T2 is on, which can change the logic input of the programmable bit in real time, and change the magnitudes of the programmable current in real time by pulses and latching. T1 is turned on after programming, and no currents exist between VBST and GND due to signal latching, thus there is no power consumption in the upper bridge domain, which improves system efficiency. In summary, the number of latch circuits is determined by the number of gears, the number of gears is equal to 2^{N}, N is the number of latch circuits, if 4 gears are required, two (4=2²) latch circuits are required, if 8 gears are required, 3 (8=2³) latch circuits are required, and so on, each bit corresponds to one latch circuit. In one embodiment, the front-end circuit (the pulses, latching and current mirror) of the programmable trimming bit implementation circuit requires only N+1 MOS transistors, N is the number of the bits, while the prior art requires 2N MOS transistors.

FIG.4 is a programmable drive current implementation circuit having four current gear circuits. In the embodiment as shown in FIG.4, the programmable drive current implementation circuit generates a four-bit decoded output signal according to the first and the second programmable current latch output signals, to control the magnitudes of currents of current sources and current sinks; the programmable drive current implementation circuit includes: a decoding circuit from two-bit to four-bit configured to generate the four-bit decoded output signal based on the first and the second programmable current latch output signals; and four current gear circuits configured to include current source drive transistors and current sink drive transistors for each gear, and control the on-off of current source drive transistors and current sink drive transistors based on the four-bit decoded output signal. HDRV is the output of Q1 (i.e., the high-side driver sampling signal), which is connected to a gate of a power transistor external to the chips. A bootstrap circuit power supply is set between VBST and SW, and the bootstrap capacitor CBS is connected externally. MP1, MP2, MP3 and MP4 are four-gear current source drive transistors, which respectively correspond to different current sources for each gear. MN1, MN2, MN3 and MN4 are four-gear current sink drive transistors, which respectively correspond to different current sinks for each gear. U42 and U43 are decoding circuits from two-bit to four-bit. B0HS and B1HS are two-bit input signals, TOHSP, T1HSP, T2HSP, and T3HSP are four-bit decoded output signals for controlling the magnitudes of currents of current sources; TOHSN, T1HSN, T2HSN, and T3HSN are four-bit decoded output signals for controlling the magnitudes of currents of current sinks; INP is the output of U44, and is used to control the on-off of the current sources and current sinks.

In FIG.4, the programmable drive current implementation circuit is configured to generate four-bit decoded output signals TOHSP, T1HSP, T2HSP and T3HSP (so as to control the magnitudes of currents of current sources), and to generate four-bit decoded output signals TOHSN, T1HSN, T2HSN and T3HSN (so as to control the magnitudes of currents of current sinks), according to the first programmable current latch output signal B0_HS and the second programmable current latch output signal B1_HS. The programmable drive current implementation circuit includes: a decoding circuit U42 from two-bit to four-bit configured to generate four-bit decoded output signals TOHSN, T1HSN, T2HSN and T3HSN based on the first and the second programmable current latch output signals B0_HS, B1_HS; a decoding circuit U43 from two-bit to four-bit configured to generate four-bit decoded output signals TOHSP, T1HSP, T2HSP and T3HSP based on the first and the second programmable current latch output signals B0_HS, B1_HS; and four current gear circuits configured to include a current source drive transistor and a current sink drive transistor for each gear, and control the on-off of current source drive transistors and current sink drive transistors based on the four-bit decoded output signal.

In one current gear circuit, INP is provided to a NOT gate, then provided to a gate of PMOS after inputting to a NOR gate and a NOT gate together with a reverse signal of TOHSP, and provided to a gate of NMOS after inputting to a NAND gate and a NOT gate together with T0HSN. A source of PMOS is connected with VBST, a drain of PMOS is connected with HDRV, a source of NMOS is connected with SW, and a drain of NMOS is connected with HDRV (i.e., the output of Q1).

The programmable drive current of the lower bridge can be implemented by a similar upper bridge programmable circuit. The present disclosure can adjust the sizes of both driving current sources and driving current sinks in real time to achieve characteristic requirements of a system. The present disclosure can meet the function of on-line programmable current driving, thereby effectively reducing the complexity and cost of system debugging.

In summary, the above-mentioned embodiments provide a detailed description of the different configurations of the driving circuit. However, the present disclosure is not limited to the configurations listed in the above embodiments. And any transformations based on the configurations provided in the above embodiments is within the protection scope of the present disclosure. Those skilled in the art can give an example based on the above embodiments.

The embodiments in the specification are described in a progressive manner, with each embodiment focusing on the differences from other embodiments, and the same or similar parts between different embodiments can be inferred from one or more other embodiments. For the system disclosed in the embodiments, as it corresponds to the method disclosed in the embodiments, the description thereof is relatively simple, and more detailed description thereof can be found in relevant sections of the method embodiments.

The above description is only a description of preferred embodiments, and does not limit the scope of the present disclosure. Any changes and modifications made by those having ordinary skill in the field that the present disclosure pertains to, in accordance with the above disclosures, shall fall within the protection scope of the claims.

## Claims

1. A programmable trimming bit implementation circuit, including:
a pulse-generating circuit configured to generate a pulse clock signal to be provided to a latch circuit;
a latch circuit configured to latch bits of programmable current input signals by applying the pulse clock signal;
a current mirror circuit configured to provide drive currents for the pulse-generating circuit and the latch circuit; and
a programmable drive current implementation circuit configured to adjust currents based on the latched bits.

2. The programmable trimming bit implementation circuit according to claim 1, wherein the pulse-generating circuit includes:
a first rising edge signal delay module configured to generate a first rising edge signal delay signal based on an initial level signal; and
a rising edge signal pulse generating module configured to generate a fixed time pulse signal based on the rising edge signal of the first rising edge signal delay signal;
wherein the pulse signal is provided to a control terminal on a branch of the current mirror circuit to generate the pulse clock signal.

3. The programmable trimming bit implementation circuit according to claim 2, wherein the number of the latch circuits is at least one, and each latch circuit includes:
a D flip-flop, whose first input terminal receives an Nth bit of the programmable current input signal, whose second input terminal receives the pulse clock signal, whose output terminal outputs a programmable current latch output signal.

4. The programmable trimming bit implementation circuit according to claim 3,
wherein in the latch circuit:
the Nth bit of the programmable current input signal and the first rising edge signal delay signal are provided to the control terminal on an Nth branch of the current mirror circuit after passing through a NAND gate, so as to generate the bits of the programmable current input signal, and then provided to the first input terminal of the D flip-flop after passing a second rising edge signal delay module;
the pulse clock signal is provided to the second input terminal of the D flip-flop after passing a third rising edge signal delay module.

5. The programmable trimming bit implementation circuit according to claim 4, wherein the current mirror circuit includes a plurality of branches and a current source providing a bias current under a power domain,
wherein the current source and each of the plurality of branches include a current mirror transistor, each of the plurality of branches also includes a high-voltage device as a control terminal, and a circuit composed of a resistor and a Zener diode connected in parallel.

6. The programmable trimming bit implementation circuit according to claim 1, wherein the programmable drive current implementation circuit is configured to generate a multi-bit decoding output signal based on a plurality of programmable current latch output signals, so as to control magnitudes of currents of current sources and current sinks.

7. The programmable trimming bit implementation circuit according to claim 1, wherein the programmable drive current implementation circuit includes:
a multi-bit decoding circuit configured to generate a multi-bit decoded output signal based on a plurality of programmable current latch output signals; and
a plurality of current gear circuits respectively including a current source drive transistor and a current sink drive transistor for each gear configured to control the on-off of the current source drive transistor and the current sink drive transistor based on the multi-bit decoding output signal.

8. A driving circuit, including the programmable trimming bit implementation circuit according to claim 1, further including:
a dead-time generating circuit configured to generate a high-side dead-time signal and a low-side dead-time signal by obtaining a high-side driver sampling signal and a low-side driver sampling signal output by the programmable trimming bit implementation circuit;
wherein there is a dead time between the high-side dead-time signal and the low-side dead-time signal, so as to avoid simultaneous conduction of power devices for both a high-side driving circuit and a low-side driving circuit during operation.

9. The driving circuit according to claim 8, further including:
a first level conversion circuit configured to perform conversion between VSS levels and VCOM levels, and convert a signal ground of input signals into a power ground, so as to avoid interference caused by noise in a chip; and
a second level conversion circuit configured to convert the input signal into a floating pulse signal referenced with a high voltage ground.

10. The driving circuit according to claim 8, further including:
a bootstrap circuit configured to include a bootstrap diode and a bootstrap capacitor, wherein the bootstrap diode is connected between a low-side power and the bootstrap capacitor, and the bootstrap capacitor is connected between the bootstrap diode and the high voltage ground;
wherein, when a low-side driving transistor is on and a high-side driving transistor is off, the high voltage ground is down, and the low-side power is charged by the bootstrap diode.
